(19) Europäisches Patentamt
European Patent Office
Office européen des brevets

(11) Veröffentlichungsnummer: **0 258 574 A2**

(12) **EUROPÄISCHE PATENTANMELDUNG**

(21) Anmeldenummer: **87109778.8**

(51) Int. Cl.[4]: **H03H 17/02**

(22) Anmeldetag: **07.07.87**

(30) Priorität: **14.08.86 DE 3627679**

(43) Veröffentlichungstag der Anmeldung: **09.03.88 Patentblatt 88/10**

(84) Benannte Vertragsstaaten: **DE FR GB IT**

(71) Anmelder: **Blaupunkt-Werke GmbH**
**Robert-Bosch-Strasse 200**
**D-3200 Hildesheim(DE)**

(72) Erfinder: **Vogelsang, Ulrich, Dr. Ing.**
**Asterweg 10b**
**D-3200 Hildesheim(DE)**

(74) Vertreter: **Eilers, Norbert, Dipl.-Phys.**
**Blaupunkt-Werke GmbH**
**Robert-Bosch-Strasse 200**
**D-3200 Hildesheim(DE)**

(54) **Filteranordnung.**

(57) Bei einer Filteranordnung zur Aufteilung eines Signals, insbesondere eines Audiosignals, in mehrere Komponenten unterschiedlicher Frequenzbereiche sind mehrere linearphasige Teilfilter vorgesehen. Die Teilfilter sind als Weichenfilter ausgebildet mit je einem Hochpaßausgang und je einem Tiefpaßausgang, deren Signale zueinander komplementäre Frequenzgänge aufweisen.

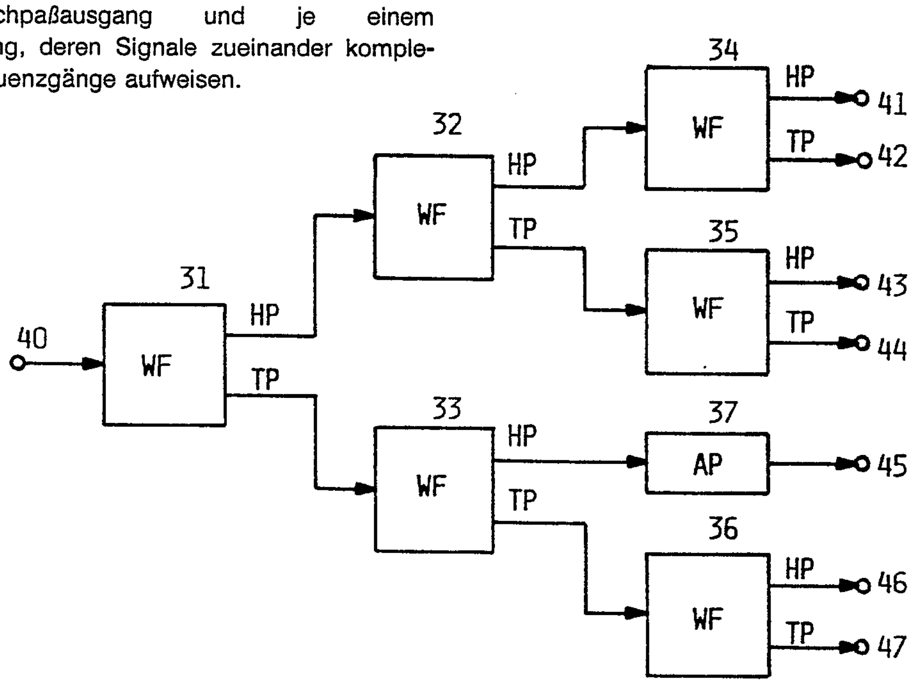


Fig.4

EP 0 258 574 A2

Xerox Copy Centre

# Filteranordnung

Die Erfindung geht aus von einer Filteranordnung nach der Gattung des Hauptanspruchs.

In der Nachrichtentechnik werden beispielsweise für die Spektralanalyse, für die spektrale Zerlegung von Signalen für weitere Signalverarbeitungen sowie für die Frequenzkompensation eines Übertragungsweges (equalizing) Filteranordnungen eingesetzt, die aus mehreren Teilfiltern bestehen und auch Filterbänke genannt werden. Diese Filteranordnungen nehmen eine Aufteilung von Signalen in mehrere Komponenten unterschiedlicher Frequenzbereiche vor. Dabei sind verschiedene Forderungen zu beachten, wie beispielsweise möglichst geringer technischer Aufwand und möglichst geringe Amplituden-und Phasenverzerrungen bei der spektralen Zerlegung.

Die erfindungsgemäße Filteranordnung mit den kennzeichnenden Merkmalen des Hauptanspruchs hat bei einer Realisierung mit einem Signalprozessor den Vorteil, daß die Anzahl von Rechen-und Speichervorgängen so gering ist, daß relativ komplexe Filteranordnungen mit zur Verfügung stehenden Signalprozessoren verwirklicht werden können. Dabei ist eine weitgehend beliebige, besonders vorteilhafte Zerlegung in Teilbänder möglich, insbesondere solcher mit konstanter relativer Bandbreite. Auch bei einer schaltungstechnischen Realisierung ergibt sich ein verhältnismäßig geringer Aufwand an Speichern, Multiplizierern und Addierern.

Durch die in den Unteransprüchen aufgeführten Maßnahmen sind vorteilhafte Weiterbildungen und Verbesserungen der im Hauptanspruch angegebenen Filteranordnung möglich.

Ausführungsbeispiele der Erfindung sind in der Zeichnung an Hand mehrerer Figuren schematisch dargestellt und in der nachfolgenden Beschreibung näher erläutert. Es zeigt:

Fig. 1 ein Weichenfilter mit komplementären Frequenzgängen in einer ersten Darstellung,

Fig. 2 ein Weichenfilter mit komplementären Frequenzgängen in einer zweiten Darstellung,

Fig. 3 ein linearphasiges Transversalfilter,

Fig. 4 ein erstes Ausführungsbeispiel einer erfindungsgemäßen Filteranordnung und

Fig. 5 ein zweites Ausführungsbeispiel.

Je nach Realisierung der erfindungsgemäßen Filteranordnung können die Figuren als Flußdiagramme für in einem Signalprozessor gespeicherte Programme oder als Blockschaltbilder einer schaltungstechnischen Realisierung betrachtet werden.

Das in Fig. 1 schematisch dargestellte Weichenfilter 1 weist einen Eingang 2 und zwei Ausgänge 3, 4 auf. Das dem Eingang 2 zugeführte Eingangssignal X(z) wird dabei in zwei Signale mit unterschiedlichen Frequenzbereichen aufgespalten, welche einerseits der Gleichung $Y_1(z) = H_{11}(z) X(z)$ und andererseits der Gleichung $Y_2(z) = H_{21}(z) X(z)$ folgen. Dabei ist $H_{11}(z)$ der Übertragungsfaktor zwischen dem Eingang 2 und dem Ausgang 3 und $H_{21}(z)$ der Übertragungsfaktor zwischen dem Eingang und dem Ausgang 4.

Fig. 2 stellt günstige Ausführungsformen eines Weichenfilters nach Fig. 1 dar, bei welchen die Frequenzgänge an den Ausgängen 3, 4 komplementär zueinander sind, d. h. über den gesamten Frequenzbereich ist der Betrag der Summe beider Übertragungsfaktoren gleich 1. Dabei werden die Signale vom Eingang 2 über ein linearphasiges Transversalfilter 5 dem Ausgang 3 und über einen Allpaß 6 einem Subtrahierer 7 zugeführt, mit deren Hilfe die Ausgangssignale des Transversalfilters 5 von den Ausgangssignalen des Allpasses 6 subtrahiert werden, wodurch am Ausgang 4 ein Signal mit dem zum Signal am Ausgang 3 komplementären Frequenzgang ansteht.

Dabei ist $H_{11}(z)$ die Übertragungsfunktion zwischen dem Eingang 2 und dem ersten Ausgang 3 und $H_{21}(z)$ die Übertragungsfunktion zwischen dem Eingang 2 und dem zweiten Ausgang 4. Abhängig vom Vorzeichen der Realteile $H_{11R}(z)$ und $H_{21R}(z)$ der Übertragungsfunktionen ergeben sich vier Realisierungsmöglichkeiten, die in Fig. 2 dargestellt sind.

Fig. 3 zeigt ein linearphasiges Transversalfilter in detaillierterer Darstellung. Dem Eingang 11 wird das zu filternde digitale Signal x(kT) zugeführt. Dabei bedeutet T die Abtastperiode und k die jeweilige Ordnungszahl der Abtastperiode. Das Eingangssignal wird 2Nmal um eine Abtastperiode T verzögert. Zur besseren Übersicht sind lediglich die Verzögerungen 12, 13, 14, 15, 16, 17 dargestellt. In digitalen Schaltungen können derartige Verzögerungen in einfacher Weise mit Hilfe von getakteten Registern verwirklicht werden. Das unverzögerte Eingangssignal x(kT) sowie das um T bis 2NT verzögerte Eingangssignal wird mit verschiedenen Koeffizienten, welche die Filtercharakteristik bestimmen, jeweils bewertet und nachfolgend zu dem Ausgangssignal y(kT) zusammengefaßt.

Durch die gerade Anzahl von Verzögerungen ergibt sich zwischen den Verzögerungen 14 und 15 ein um eine mittlere Zeit verzögertes Signal, das mit Hilfe eines Multiplizierers 18 mit den Koeffizienten $h_N$bewertet und dem Addierer 19 zugeführt wird. Die jeweils um n Abtastperioden weniger und um n Abtastperioden mehr verzögerten Signale werden jeweils in einem Addierer zusammengefaßt, in einem Multiplizierer mit dem Koeffizienten $h_{(N-n)}$ bewertet und über einen Addierer dem Ausgangssignal zugefügt. Dieses ist beispielhaft mit den Addierern 20, 22, 25, den Multiplizierern 21, 23, 26 und den Addierern 19, 24, 27 dargestellt. Dabei ist n = 1 ... N. Am Ausgang 28 steht das Ausgangssignal y(kT) zur Verfügung. Im Zusammenhang mit Fig. 3 beschriebene Filter sind an sich bekannt und sind beispielsweise in Lücker, Raimund: Grundlagen digitaler Filter beschrieben.

Bei der Filteranordnung nach Fig. 4 sind sechs Weichenfilter 31, 32, 33, 34, 35, 36 zu einer Filteranordnung zusammengefaßt. Dabei sind jeweils der Hochpaßausgang mit HP und der Tiefpaßausgang mit TP bezeichnet. Zum Ausgleich der Laufzeit des Weichenfilters 36 ist dem Hochpaßausgang des Weichenfilters 33 ein Allpaß 37 nachgeschaltet.

Mit der Filteranordnung nach Fig. 4 wird der von dem bei 40 zugeführten Eingangssignal eingenommene Frequenzbereich in sieben Teilbereiche aufgeteilt. Entsprechende Signale sind an den Ausgängen 41 bis 47 entnehmbar. Durch die Wahl der Zahl der Koeffizienten und der Werte der Koeffizienten der einzelnen Weichenfilter sowie durch die Wahl der Abtastfrequenz ist die jeweilige Übergangsfrequenz zwischen dem Tiefpaß-und dem Hochpaßausgang weitgehend wählbar, so daß die Breite der Frequenzbereiche den jeweiligen Anwendungsfällen angepaßt werden kann. Da insbesondere die Koeffizienten, welche den Multiplizierern 18, 21, 23, 26 (Fig. 3) zugeführt werden, leicht veränderbar sind, können erfindungsgemäß ausgeführte Filteranordnungen als steuerbare oder adaptive Filter ausgeführt werden.

Bei dem Ausführungsbeispiel nach Fig. 5 ist jeweils an den Tiefpaßausgang eines Weichenfilters ein weiteres Weichenfilter angeschlossen. Lediglich der Hochpaßausgang des ersten Weichenfilters 51 ist über einen Allpaß 52 mit einem weiteren Weichenfilter 53 verbunden, deren Ausgangssignale über je einen Multiplizierer 54, 55 einem Addierer 56 zugeführt sind, dessen Ausgang mit dem weiteren Addierer 57 verbunden ist. Der Tiefpaßausgang ist über einen Allpaß 58 mit dem Weichenfilter 59 verbunden, dessen Hochpaßausgang über einen Multiplizierer 60 mit dem Addierer 57 verbunden ist.

Das am Tiefpaßausgang des Weichenfilters 59 anstehende Signal wird in dem Weichenfilter 61 wiederum aufgespalten, dessen Tiefpaß-Ausgangssignal wiederum in dem Weichenfilter 62 und dessen Tiefpaß-Ausgangssignal in dem Weichenfilter 63. Die Hochpaß-Ausgangssignale werden über die Multiplizierer 64, 65, 66, die Addierer 67 und 68 sowie die Allpässe 69, 70 und 71 zum Addierer 72 geleitet. Außerdem wird dem Addierer 72 über einen Multiplizierer 73 das Tiefpaß-Ausgangssignal des Weichenfilters 63 zugeführt. Der Ausgang 74 des Addierers 72 stellt den Ausgang der Filteranordnung dar.

Die an Hand von Fig. 5 erläuterte Struktur einer Filteranordnung kommt einer Aufteilung des gesamten Frequenzbandes in Teilbänder gleicher relativer Bandbreite entgegen. So kann beispielsweise durch Kaskadierung von Weichenfiltern, welche das ihnen zugeführte Frequenzband zur Hälfte aufspalten, für elektroakustische Zwecke eine Filteranordnung geschaffen werden, deren Teilbänder jeweils eine Oktave umfassen.

**Ansprüche**

1. Filteranordnung zur Aufteilung eines Signals, insbesondere eines Audiosignals, in mehrere Komponenten unterschiedlicher Frequenzbereiche, dadurch gekennzeichnet,
daß mehrere linearphasige Teilfilter (1) vorgesehen sind.

2. Filteranordnung nach Anspruch 1, dadurch gekennzeichnet,
daß die Teilfilter als Weichenfilter (1) ausgebildet sind mit je einem Hochpaßausgang und je einem Tiefpaßausgang, die zueinander komplementäre Frequenzgänge aufweisen.

3. Filteranordnung nach Anspruch 2, dadurch gekennzeichnet,
daß der eine Ausgang (3) vom Ausgang eines linearphasigen Transversalfilters (5) und der andere Ausgang (4) vom Ausgang eines Subtrahierers (7) gebildet wird, welchem phasen-und vorzeichenrichtig das Eingangs-und das Ausgangssignal des linearphasigen Transversalfilters (5) zugeführt sind.

4. Filteranordnung nach einem der vorhergenden Ansprüche, dadurch gekennzeichnet,
daß eine Aufteilung in Frequenzbänder durch Kaskadierung der Teilfilter erfolgt.

5. Filteranordnung nach einem der vorhergenden Ansprüche, dadurch gekennzeichnet,
daß Sperrdämpfung, Durchlaßdämpfung, Sperrfrequenz, Durchlaßfrequenz und Abtastfrequenz derart gewählt sind, daß bei vorgegebener Struktur der Teilfilter eine Anzahl von Filterkoeffizienten gleich null ist.

6. Filteranordnung nach einem der vorhergenden Ansprüche, dadurch gekennzeichnet,
daß die Koeffizienten der Teilfilter durch Skalierung aus vorgegebenen Übertragungsfunktionen $H\mu(z)$ mittels Transformation $z := z^K$ gewonnen werden.

7. Filteranordnung nach einem der Anspruche 1 bis 4, dadurch gekennzeichnet,
daß die Frequenzaufteilung steuerbar ist.

8. Filteranordnung nach einem der vorhergenden Ansprüche, dadurch gekennzeichnet, daß an die Ausgänge eines ersten Weichenfilters (31) an je ein zweites und ein drittes Weichenfilter (32, 33) und an die Ausgänge des zweiten und des dritten Weichenfilters weitere Weichenfilter (34, 35, 36) angeschlossen sind.

9. Filteranordnung nach einem der Ansprüche 1 bis 7, dadurch gekennzeichnet, daß die Ausgangssignale der Weichenfilter über jeweils einen Multiplizierer Addierern zugeführt sind.

10. Filteranordnung nach einem der Ansprüche 2 bis 7, dadurch gekennzeichnet, daß die Weichenfilter derart kaskadiert sind, daß ein Tiefpaßausgang (TP) eines Weichenfilters (59, 61, 62) jeweils mit dem Eingang des folgenden Weichenfilters (61, 62, 63) verbunden ist und daß der Hochpaßausgang (HP) des jeweils einen Weichenfilters (59, 61, 62) über einen Multiplizierer (60, 64, 65), einen Addierer (57, 67, 68), welchem die Hochpaßsignale vorangegangener Weichenfilter (53, 59, 61) zugeführt sind, und einen Allpaß (69, 70, 71) mit einem weiteren Addierer (67, 68, 72) verbunden ist, welcher ferner mit dem über einen weiteren Multiplizierer (64, 65, 66) geleiteten Hochpaßsignal des folgenden Weichenfilters (61, 62, 63) beaufschlagt ist.

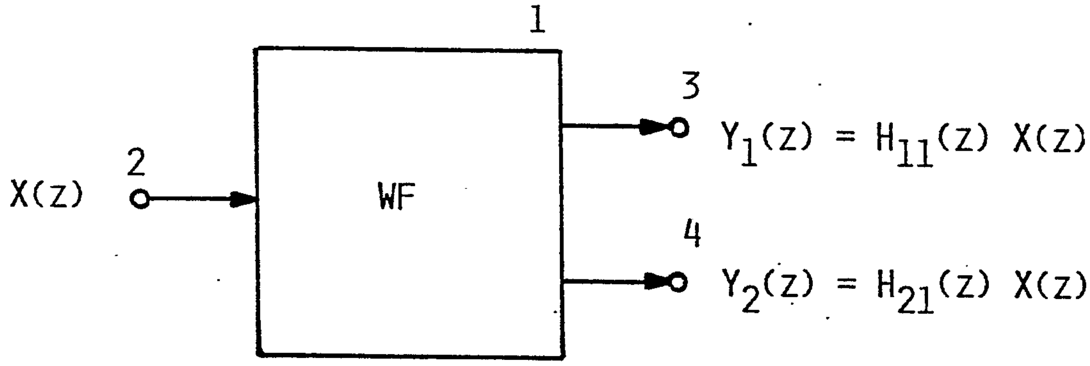
1
WF
2
X(z)
3
$Y_1(z) = H_{11}(z)\ X(z)$
4
$Y_2(z) = H_{21}(z)\ X(z)$

Fig. 1

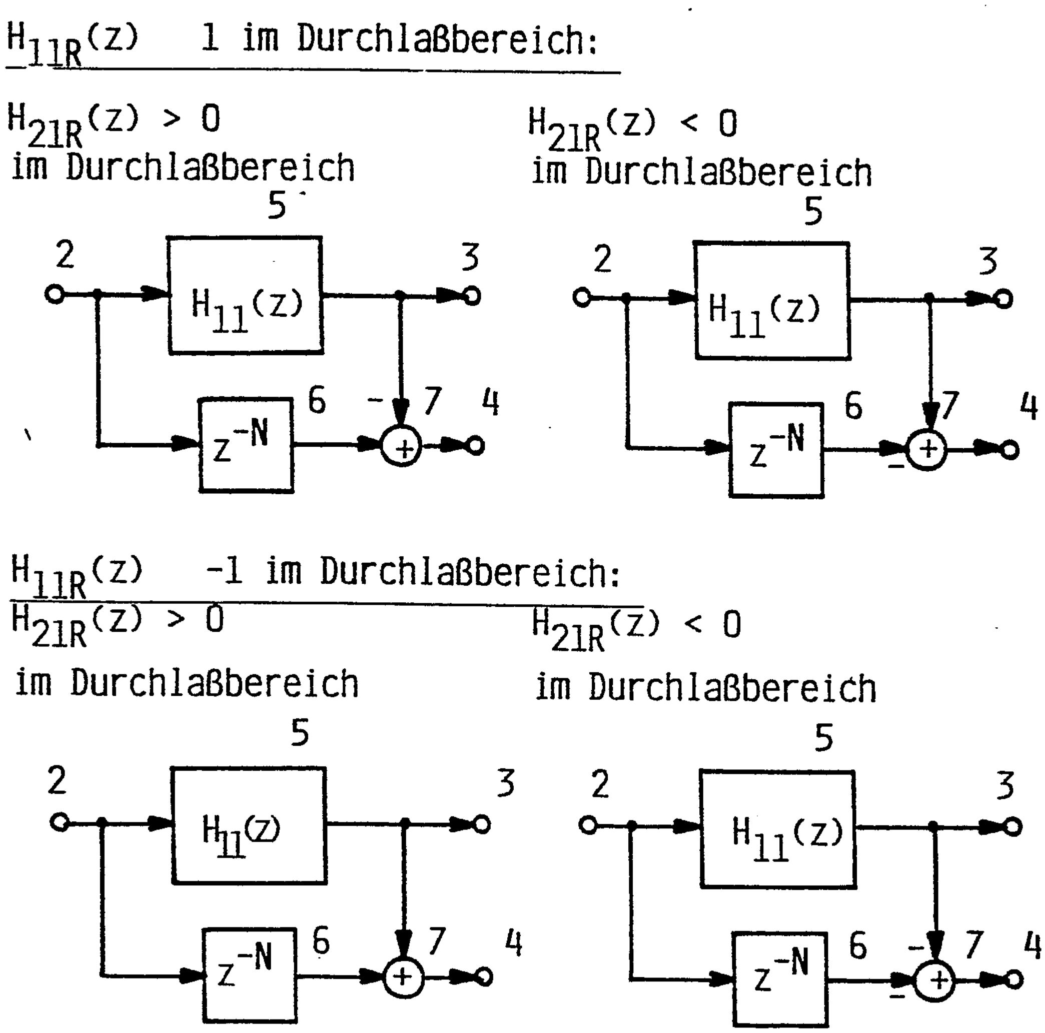
$H_{11R}(z)$ 1 im Durchlaßbereich:
$H_{21R}(z) > 0$
im Durchlaßbereich
$H_{21R}(z) < 0$
im Durchlaßbereich
5
2
3
$H_{11}(z)$
6
7
4
$z^{-N}$
-
$H_{11R}(z)$ -1 im Durchlaßbereich:
$H_{21R}(z) > 0$
im Durchlaßbereich
$H_{21R}(z) < 0$
im Durchlaßbereich

Fig. 2

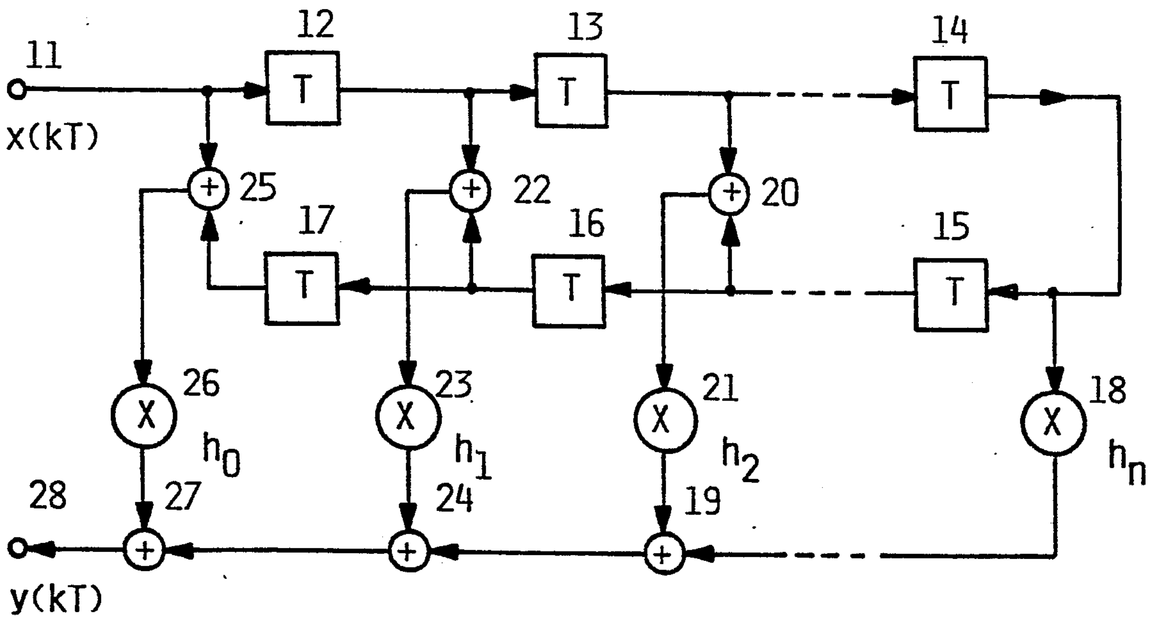
11
x(kT)
12
T
13
T
14
T
25
22
20
17
T
16
T
15
T
26
X
h0
23
X
h1
21
X
h2
18
X
hn
28
27
24
19
y(kT)

Fig.3

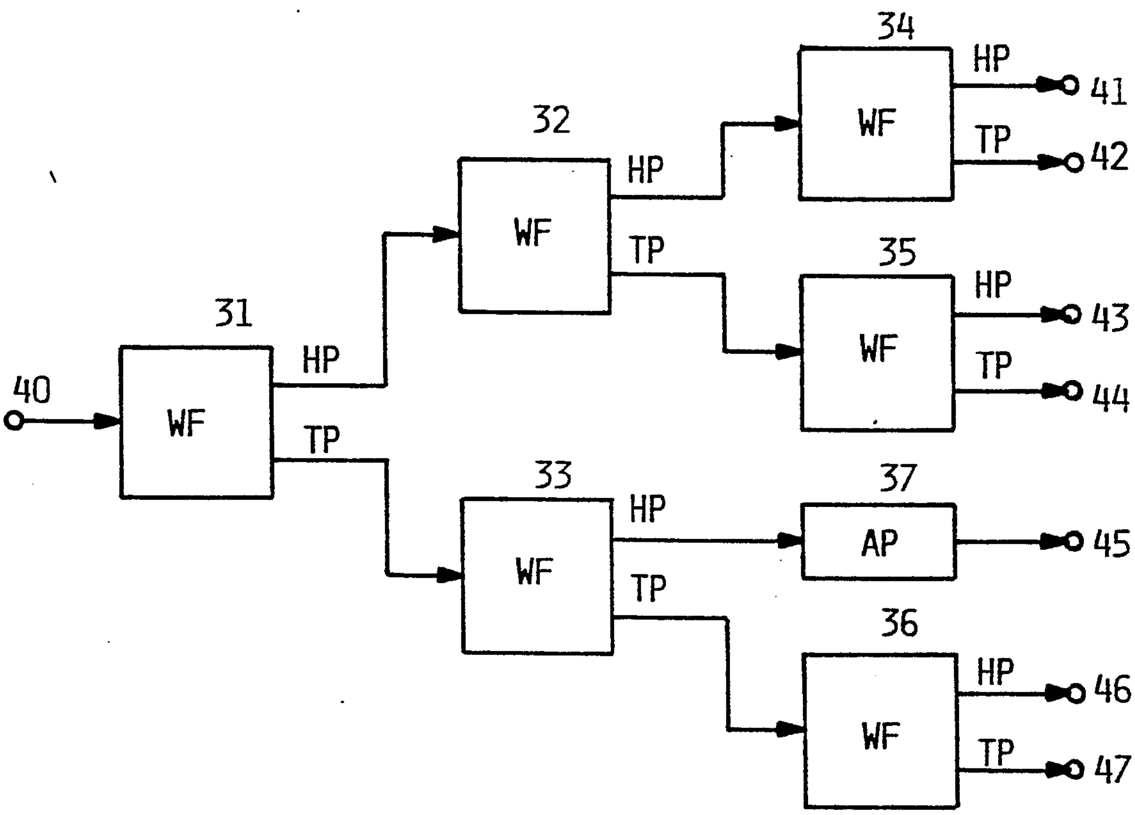
40
31
WF
HP
TP
32
WF
HP
TP
33
WF
HP
TP
34
WF
HP
TP
41
42
35
WF
HP
TP
43
44
37
AP
45
36
WF
HP
TP
46
47

Fig.4

R.-Nr. 1931

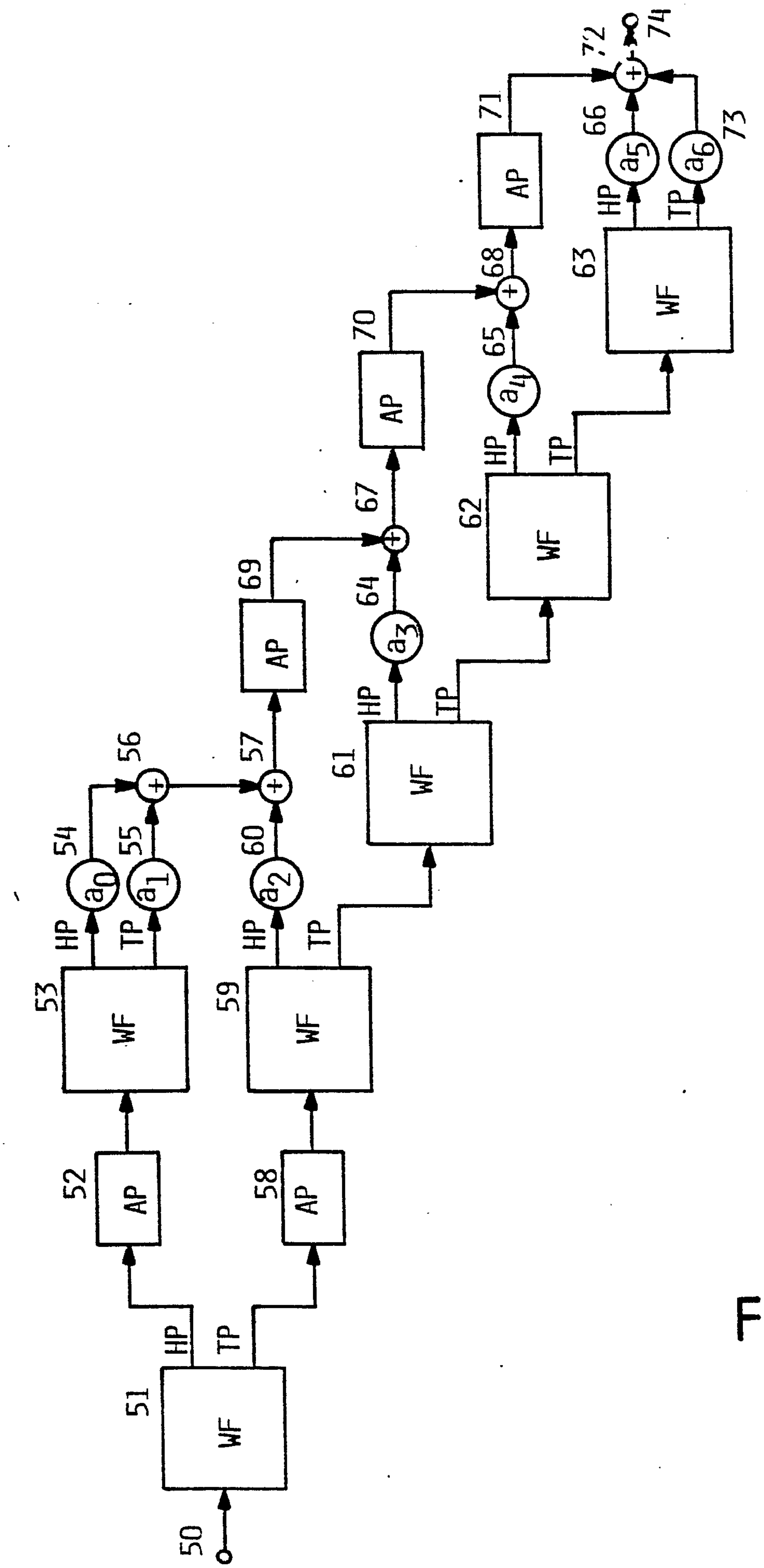


Fig. 5